# FASCICULE DE BREVET EUROPEEN

(11) **EP 3 592 716 B1**
(45) Date de publication et mention de la délivrance du brevet: **18.08.2021**
(21) Numéro de dépôt: 18713309.5
(22) Date de dépôt: 05.03.2018
(51) Int. Cl.: C04B 35/80, C04B 38/06, C04B 35/14, C04B 35/18, C04B 35/565, C04B 35/573, C04B 35/583, C04B 35/628

(54) **PROCÉDÉ DE RÉALISATION D'UNE PRÉFORME FIBREUSE CONSOLIDÉE**
VERFAHREN ZUR HERSTELLUNG EINER KONSOLIDIERTEN FASERVORFORM
METHOD FOR PRODUCING A CONSOLIDATED FIBROUS PREFORM

(30) Priorité: 07.03.2017 FR 1700224
(43) Date de publication de la demande: 15.01.2020
(73) Titulaire: Safran Ceramics, 33185 Le Haillan (FR); Safran, 75015 Paris (FR)
(72) Inventeur: TESSON, Thierry, Guy, Xavier, 77550 Moissy-Cramayel Cedex (FR); CARLIN, Maxime, François, Roger, 77550 Moissy-Cramayel Cedex (FR); THIBAUD, Simon, 77550 Moissy-Cramayel Cedex (FR); DUPONT, Rémy, 77550 Moissy-Cramayel Cedex (FR); BOHLI, Ramzi, 77550 Moissy-Cramayel Cedex (FR)
(74) Mandataire: Cabinet Beau de Loménie
(86) Numéro de dépôt international: PCT/FR2018/050492
(87) Numéro de publication internationale: WO 2018/162827

(56) Documents cités:
- WO-A1-01/68556
- WO-A1-2016/102839
- US-A1- 2004 105 969

## Description

### Arrière-plan de l'invention

L'invention concerne la consolidation des préformes fibreuses et la fabrication de pièces en matériau composite à matrice céramique ou au moins partiellement en céramique, désigné ci-après par matériau CMC.

Un domaine d'application de l'invention est la réalisation de pièces destinées à être exposées en service à des températures élevées, notamment dans des domaines aéronautique et spatial, en particulier des pièces de parties chaudes de turbomachines aéronautiques, étant noté que l'invention peut être appliquée dans d'autres domaines, par exemple le domaine des turbines à gaz industrielles.

Les matériaux composites CMC possèdent des bonnes propriétés thermostructurales, c'est-à-dire des propriétés mécaniques élevées qui les rendent aptes à constituer des pièces structurales et la capacité de conserver ces propriétés à hautes températures.

L'utilisation de matériaux CMC à la place de matériaux métalliques pour des pièces exposées en service à des températures élevées a donc été préconisée, d'autant que les matériaux CMC présentent une masse volumique sensiblement plus faible que les matériaux métalliques auxquels ils se substituent.

Un procédé bien connu pour la fabrication de pièces en matériau CMC comprend les étapes suivantes :
- tissage d'une texture fibreuse à partir de strates fibreuses de fibres de carbone ou de carbure de silicium (SiC),
- consolidation d'une préforme fibreuse par dépôt d'une interphase à la surface des fibres de la texture réalisée par infiltration chimique en phase gazeuse (CVI), la texture fibreuse étant maintenue dans outillage de conformation durant la CVI,
- injection d'une barbotine dans la préforme fibreuse (« Slurry Cast » ou « Slurry Transfer Molding »),
- infiltration de la préforme avec une composition à base de silicium fondu de manière à former une matrice céramique, processus de densification connu sous la désignation processus MI ("Melt Infiltration"),
- usinages,
- formation d'un revêtement.

Ce procédé de fabrication de pièces en matériau CMC nécessite d'utiliser un outillage de conformation lors du dépôt de l'interphase. Ce type d'outillage correspond à un moule multi-perforé dont la forme interne permet de conformer la texture fibreuse et les multiperforations de figer la texture dans sa géométrie en permettant à la phase gazeuse utilisée lors du dépôt de l'interphase de pénétrer dans la texture et de la consolider. L'outillage de conformation est réalisé, par exemple, en graphite car c'est un matériau compatible avec l'atmosphère réactive utilisée lors du dépôt d'interphase tout en présentant une innocuité vis-à-vis des fibres de carbone ou de carbure de silicium.

Ce type d'outillage de conformation présente cependant les inconvénients suivants :
- coût élevé (usinage de bloc de graphite épuré),
- fragilité (risque de casse lors du serrage des blocs de graphite, mauvaise tenue mécanique vis-à-vis des efforts),
- durée de vie limitée (encrassement des multiperforations et des systèmes de serrage),
- nécessité de remplacer fréquemment les organes de serrage de l'outillage,
- encombrement important en raison des organes de serrage utilisés pour assembler et serrer l'outillage

US 2004/105969 A1 divulgue un procédé de réalisation d'une préforme fibreuse consolidée destinée à la fabrication d'une pièce en matériau composite.

### Objet et résumé de l'invention

L'invention a notamment pour but de fournir une solution pour la consolidation d'une préforme fibreuse destinée à la fabrication d'une pièce en matériau composite ne présentant pas les inconvénients précités.

Ce but est atteint grâce à un procédé de réalisation d'une préforme fibreuse consolidée destinée à la fabrication d'une pièce en matériau composite, comprenant les étapes de :
- mise en forme d'une texture fibreuse dans un moule métallique chauffé, la texture étant imprégnée préalablement d'un matériau fugace ou fugitif, ou mise en forme d'une texture fibreuse dans un moule métallique et injection d'un matériau fugace ou fugitif dans la texture fibreuse maintenue en forme dans le moule métallique,
- refroidissement du moule,
- démoulage de la préforme fibreuse figée,
- enrobage de la préforme fibreuse avec une barbotine contenant une poudre de particules céramique ou carbone,
- traitement thermique de la préforme fibreuse enrobée de manière à former une carapace poreuse autour de la préforme fibreuse par consolidation de la barbotine et à éliminer le matériau fugace ou fugitif présent dans la préforme fibreuse,
- consolidation par infiltration chimique en phase gazeuse de la préforme fibreuse.

Le procédé selon l'invention permet de réduire significativement les coûts de production, en particulier grâce à l'utilisation d'un moule métallique qui présente une solidité et une durée de vie bien plus importante qu'un outillage de confirmation en graphite, ce qui permet d'économiser le coût récurrent de remplacement des conformateurs en graphite. La maîtrise dimensionnelle de la préforme est en outre optimisée avec une mise en forme dans un moule métallique par rapport à un moule en graphite. En effet, la forme finale brute de la pièce (hors revêtement) est définie par :
- le moule métallique, et
- les surépaisseurs ou éventuelles déformations engendrées par les étapes de fabrication ultérieure de la pièce telles que l'infiltration chimique en phase gazeuse, l'injection de barbotine (« Slurry Cast » ou « Slurry Transfer Molding ») ou l'infiltration avec une composition à base de silicium fondu MI ("Melt Infiltration") de la préforme. En outre, une fois figée en forme dans la carapace poreuse, la préforme peut être soumise aux étapes ultérieures de fabrication d'une pièce en matériau composite sans avoir à utiliser d'outillage de conformation.

Selon un premier aspect du procédé de l'invention, avant l'étape de consolidation par infiltration chimique en phase gazeuse de la préforme fibreuse, des perçages sont réalisés dans la carapace. Cela permet d'augmenter la porosité de la carapace et d'augmenter l'efficacité des infiltrations et/ou des injections de matière dans la préforme.

Selon un deuxième aspect du procédé de l'invention, le moule comporte une cavité de moulage présentant une forme correspondant à la forme de la préforme fibreuse à réaliser et un ou plusieurs canaux s'étendant à partir de la cavité de moulage, le ou les canaux étant remplis par le matériau fugace ou fugitif lors de l'injection de la texture fibreuse dans le moule, le matériau fugace ou fugitif formant des éléments en saillie sur la surface de la préforme après démoulage de ladite préforme, les éléments en saillie étant éliminés lors du traitement thermique de manière à former des ouvertures de passage dans la carapace. On évite ainsi d'avoir à percer la carapace après sa formation lorsque l'on souhaite augmenter sa porosité. Les éléments en saillie peuvent être également rapportés ou formés sur la préforme, après son démoulage et avant son enrobage avec la barbotine destinée à former la carapace, ces éléments pouvant être par exemple rapportés manuellement ou par fabrication additive sur support, le support étant ici la préforme consolidée.

Selon un troisième aspect du procédé de l'invention, le matériau fugace ou fugitif correspond à une cire à injecter ou une résine fugitive.

Selon un quatrième aspect du procédé de l'invention, la préforme fibreuse est formée par une texture fibreuse réalisée en une seule pièce par tissage tridimensionnel ou multicouche ou à partir d'une pluralité de strates fibreuses bidimensionnelles. La texture fibreuse peut être réalisée notammentà partir de fibres de carbure de silicium (SiC), de nitrure de silicium (Si₃N₄) ou de carbone (C).

Selon un cinquième aspect du procédé de l'invention, l'étape de consolidation par infiltration chimique en phase gazeuse de la préforme fibreuse comprend le dépôt d'une interphase dans la préforme, l'interphase étant constituée d'un des matériaux suivants : carbone pyrolytique (PyC), nitrure de bore (BN), carbone dopé au bore (BC) et carbure de silicium (SiC).

L'invention concerne également un procédé de fabrication d'une pièce en matériau composite comprenant la réalisation d'une préforme fibreuse consolidée selon le procédé de l'invention et, après l'étape de consolidation par infiltration chimique en phase gazeuse, une étape de décochage de la carapace, une étape d'injection d'une barbotine dans la préforme fibreuse et une étape d'infiltration de la préforme avec une composition à base de silicium fondu de manière à former une matrice céramique dans ladite préforme.

L'invention concerne encore un procédé de fabrication d'une pièce en matériau composite comprenant la réalisation d'une préforme fibreuse consolidée selon le procédé de l'invention et, après l'étape de consolidation par infiltration chimique en phase gazeuse, une étape d'injection d'une barbotine dans la préforme fibreuse et une étape d'infiltration de la préforme avec une composition à base de silicium fondu de manière à former une matrice céramique dans ladite préforme.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- les figures 1 à 8 sont des vues schématiques montrant la consolidation d'une préforme fibreuse conformément à un mode de réalisation de l'invention,
- la figure 9 est une schématique en coupe d'une installation d'infiltration chimique en phase gazeuse utilisée pour la densification d'une préforme fibreuse,
- la figure 10 est une vue schématique en coupe d'une préforme fibreuse consolidée conformément à un mode de réalisation de l'invention,
- les figures 11 et 12 sont des vue schématiques en coupe montrant la réalisation de segments sur la surface d'une préforme fibreuse consolidée conformément à une variante de mise en œuvre de l'invention, et
- la figure 13 est un ordinogramme des étapes d'un procédé de consolidation d'une préforme fibreuse conformément à un mode de réalisation de l'invention.

### Description détaillée de modes de réalisation

L'invention propose tout d'abord un procédé de réalisation d'une préforme fibreuse consolidée destinée à la fabrication de pièces en matériau composite à matrice céramique (CMC), c'est-à-dire un matériau formé d'un renfort en fibres de carbone ou céramique densifié par une matrice au moins partiellement céramique.

Le procédé de l'invention est remarquable en ce qu'il n'utilise pas d'outillage de conformation en graphite pour la consolidation par infiltration chimique en phase gazeuse de la préforme fibreuse. Comme expliqué ci-après en détails et conformément à l'invention, l'outillage de conformation en graphite est remplacé par une carapace sacrificielle formée autour de le texture fibreuse mise en forme, la carapace permettant de maintenir la texture fibreuse en forme lors de sa consolidation par infiltration chimique en phase gazeuse.

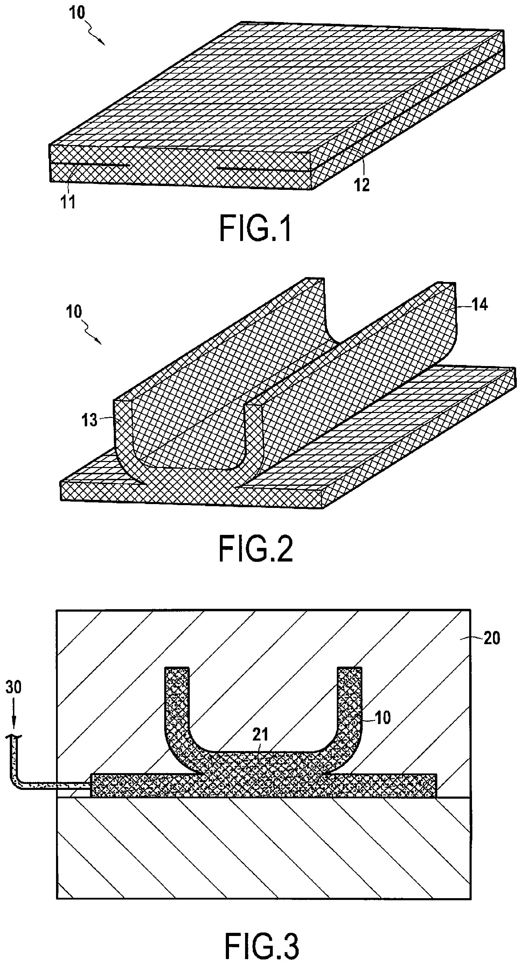

Un mode de réalisation d'un matériau CMC conforme au procédé de l'invention sera décrit en référence aux figures 1 à 13.

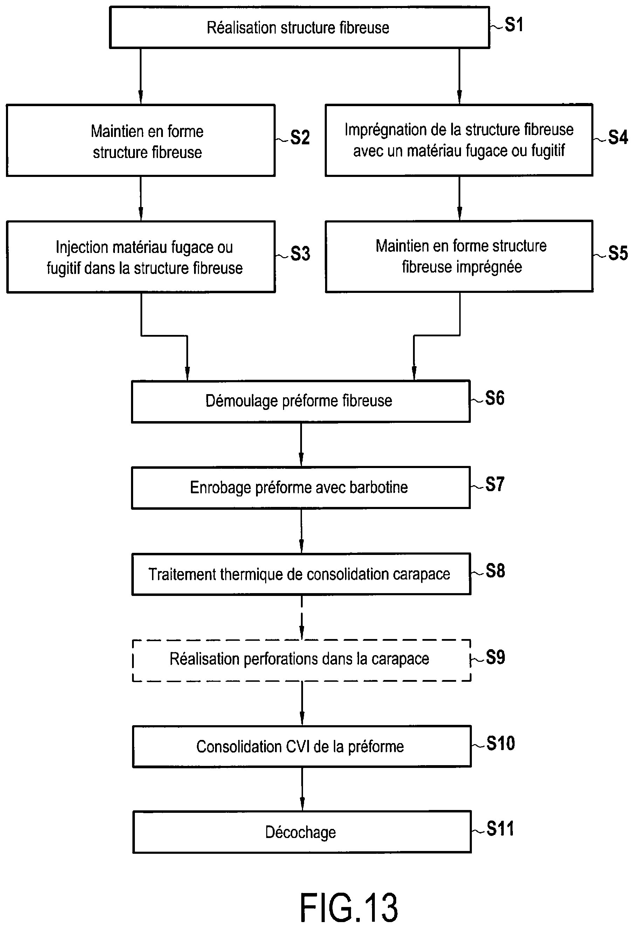

Une première étape S1 (figure 13) consiste à réaliser une texture fibreuse 10 à partir de laquelle une préforme fibreuse ayant une forme voisine de celle d'une pièce à fabriquer sera réalisée (figure 1). Une telle texture fibreuse peut être obtenue par tissage multicouches ou tridimensionnel à partir de fils ou câbles. Il est possible aussi de partir de textures fibreuses bidimensionnelles telles que des tissus ou des nappes de fils ou câbles pour former des strates qui seront ensuite drapées sur une forme et éventuellement liées entre elles par exemple par couture ou implantation de fils. Dans l'exemple décrit ici, la texture fibreuse 10 est destinée à former un secteur d'anneau de turbine en matériau CMC présentant une forme de Pi ou π inversé avec une base annulaire à partir de laquelle s'étendent deux pattes d'accrochage. A cet effet, la texture fibreuse 10 est réalisée par tissage tridimensionnelle de fils de carbure de silicium ou de carbone avec aménagement de zones de déliaisons 11 et 12 permettant d'écarter des parties de texture 13 et 14 correspondant aux brides d'accrochage du secteur d'anneau (figure 2).

Le tissage peut être de type interlock, comme illustré. D'autres armures de tissage tridimensionnel ou multicouches peuvent être utilisées comme par exemple des armures multi-toile ou multi-satin. On pourra notamment se référer au document WO 2006/136755.

Les fibres constitutives de la texture fibreuse sont de préférence des fibres en céramique, par exemple des fibres formées essentiellement de carbure de silicium SiC (désignées ci-après fibres SiC) ou de nitrure de silicium Si₃N₄. On peut notamment utiliser des fibres SiC commercialisées sous les dénominations « Tyranno ZMI », « Tyranno Lox-M » et « Tyranno SA3 » par la société japonais Ube Industries, Ltd ou « Nicalon », « Hi-Nicalon » et « Hi-Nicalon(S) » par la société japonaise Nippon Carbon. Il est possible en variante d'utiliser des fibres de carbone.

De façon connue, dans le cas de fibres en céramique, notamment de fibres SiC, un traitement de surface de celles-ci préalablement à la formation d'un dépôt d'interphase est de préférence réalisé pour éliminer l'ensimage et une couche superficielle d'oxyde tel que de la silice SiO₂ présents sur les fibres.

Les étapes suivantes consistent à maintenir en forme la texture fibreuse dans un moule métallique 20 et à figer celle-ci pour obtenir une préforme ayant une forme voisine de celle de la pièce à fabriquer (figure 3). A cet effet, la texture fibreuse 10 est placée dans le moule métallique 20 dont la cavité de moulage 21 correspond à la forme de la pièce à fabriquer (étape S2), un matériau fugace ou fugitif 30 étant injecté dans la texture ainsi maintenue en forme (étape S3) (figure 3). Selon une variante de mise en œuvre, la texture fibreuse 10 peut être imprégnée avec un matériau fugace ou fugitif (étape S4) avant sa mise en forme dans le moule métallique (étape S5). Le matériau fugace ou fugitif est de présente de préférence une température de fusion et d'évaporation significativement supérieure à la température ambiante (20°C ± 5°C), par exemple supérieure d'au moins 50°C par rapport à la température ambiante (20°C ± 5°C). Le matériau fugace ou fugitif peut être constitué notamment d'une cire à injecter ou d'une résine fugitive, par exemple une résine acrylique PPMA ou de l'alcool polyvinylique (PVA).

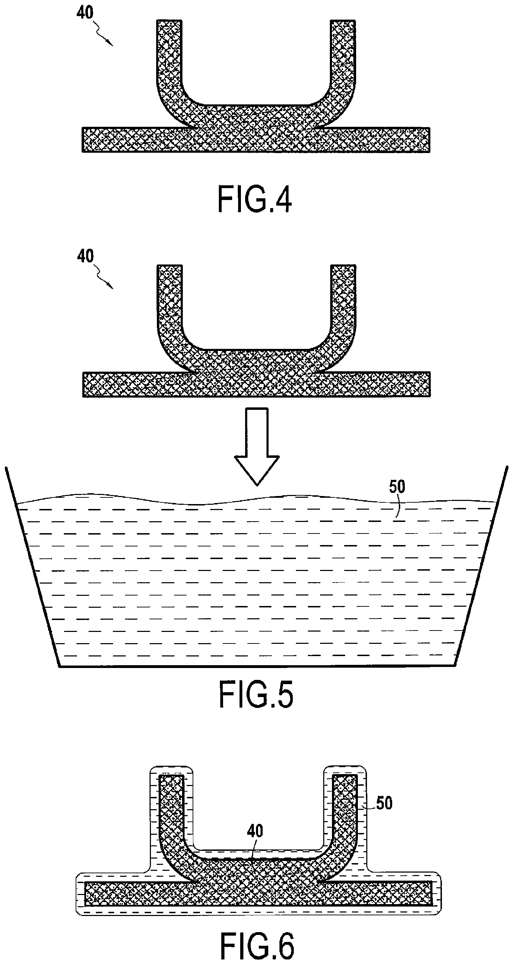

Après refroidissement du moule métallique, une préforme fibreuse 40 est démoulée, la préforme étant figée et autoporteuse grâce à la présence du matériau fugace ou fugitif à l'état solide dans celle-ci (étape S6, figure 4).

La préforme fibreuse 40 ainsi réalisée est enrobée avec une barbotine 50 contenant une poudre de particules céramique ou carbone (étape S7). La poudre peut être constituée d'un ou plusieurs des éléments suivants : particules de type oxyde (silice, aluminosilicate, etc.), particules de carbure de silicium avec ou sans silice colloïdale, particules de carbone. L'enrobage de la préforme fibreuse peut être réalisé par trempage de cette dernière dans un bain de barbotine 50 (figure 5) ou par toute autre techniques connues de l'homme du métier (trempage, aspersion, enduction, pistolage, etc.). Un montage en grappe de plusieurs préformes peut être envisagé pour augmenter les cadences de production et réduire le coût de fabrication unitaire des pièces.

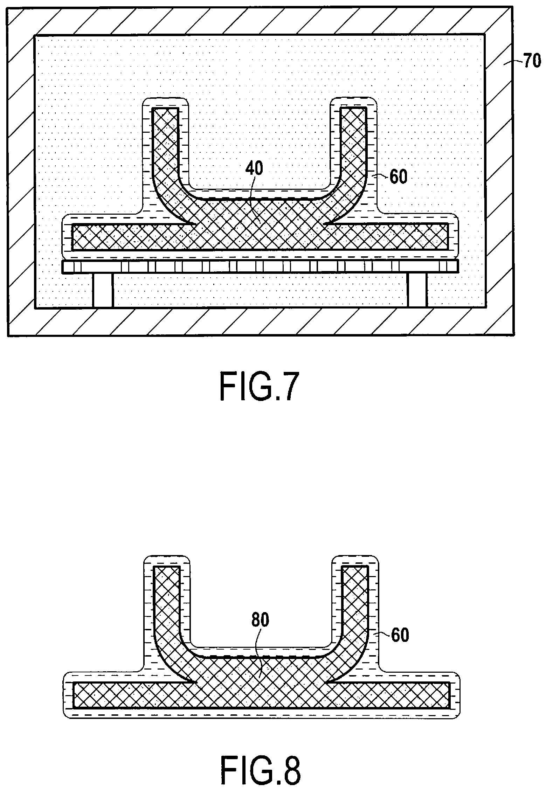

La préforme fibreuse 40 ainsi enrobée d'une couche de barbotine 50 (figure 6) est soumise à un traitement thermique dans un four 70 afin de fritter ou pré-fritter les particules présentes dans la barbotine de manière à consolider la couche de barbotine présente à la surface de la préforme 40 et former une carapace 60 autour de la préforme 40, la carapace 60 ainsi formée étant poreuse (étape S8, figure 7). De manière connue, le taux de particules et/ou la taille des particules sont ajustés de manière à obtenir une carapace présentant un réseau de porosités compatible avec une consolidation de la préforme par voie gazeuse. Le retrait du matériau fugace ou fugitif de la préforme 40 est également réalisé pendant cette étape, le traitement thermique étant réalisé à une température supérieure à la température de fusion et/ou d'évaporation du matériau fugace ou fugitif.

Des évents permettant de faciliter l'évacuation du matériau fugace ou fugitif peuvent être ménagés dans la carapace entourant la préforme. Ces évents peuvent être ménagés lors de l'enrobage de la préforme avec la barbotine en masquant certaines parties de la préforme et formant des passages dans la carapace une fois le traitement thermique de consolidation réalisé. Les évents peuvent être également usinés dans la carapace après sa formation. Ces évents peuvent être éventuellement rebouchés après l'élimination du matériau fugace ou fugitif.

On obtient ainsi une préforme 80 correspondant à la préforme 60 dans laquelle le réseau de porosité présent entre les fibres a été rouvert par le retrait du matériau fugace ou fugitif, la géométrie de la préforme 80 étant quant à elle maintenue grâce à la présence de la carapace 60 (figure 8). La carapace 60 est poreuse et donc compatible pour une infiltration chimique en phase gazeuse de la préforme 80.

De manière optionnelle, des perforations peuvent être réalisées dans la carapace afin d'augmenter la porosité de la carapace et faciliter ainsi le passage des gaz d'infiltration (étape S9).

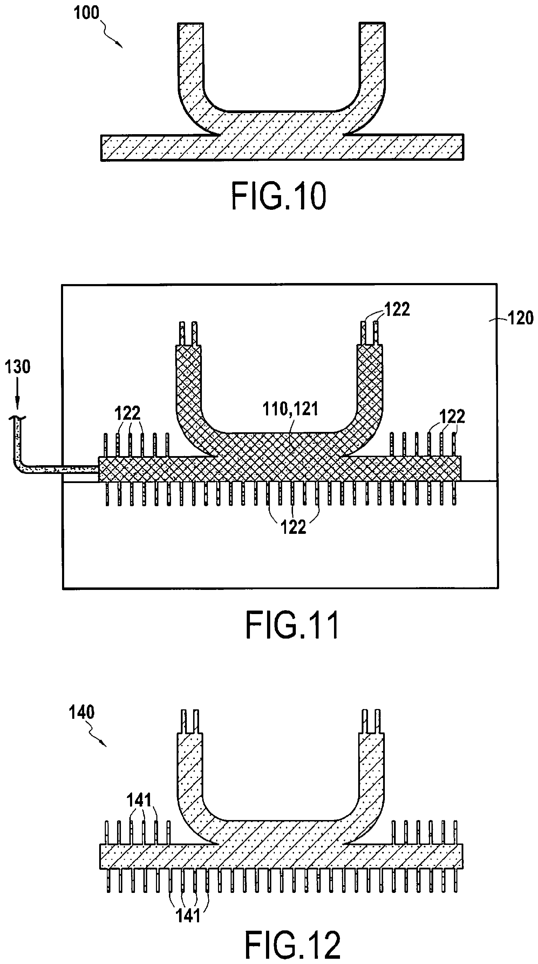

Des trous de passages peuvent être également réalisés lors de la formation de la carapace. A cet effet, comme illustré sur la figure 11, on utilise un moule métallique 120 qui comporte, en outre d'une cavité de moulage 121 correspondant à la forme de la pièce à fabriquer, une pluralité de canaux 122 s'étendant à la périphérie de la cavité de moulage 121 et communicant avec celle-ci. Ainsi, lors de l'injection d'un matériau fugace ou fugitif 130 dans le moule 12, celui-ci comblera non seulement la porosité présente dans la texture fibreuse 110 maintenue dans la cavité de moulage 121 mais aussi les canaux 122. Après refroidissement et démoulage, on obtient, comme représentée sur la figure 12, une préforme 140 qui présente à sa surface une pluralité de pointes ou picots 141 en matériau fugace ou fugitif qui vont permettre de réserver des passages lors de l'enrobage ultérieure de la préforme avec la barbotine. Les segments 141 sont ensuite éliminés pendant le traitement thermique de consolidation de la barbotine de manière à former des trous ou passages dans la carapace formée. On évite ainsi d'avoir à percer la carapace après sa formation. Les segments peuvent avoir des formes variées, en particulier non rectilignes, permettant de définir des géométries différentes de circulation des gaz dans la carapace.

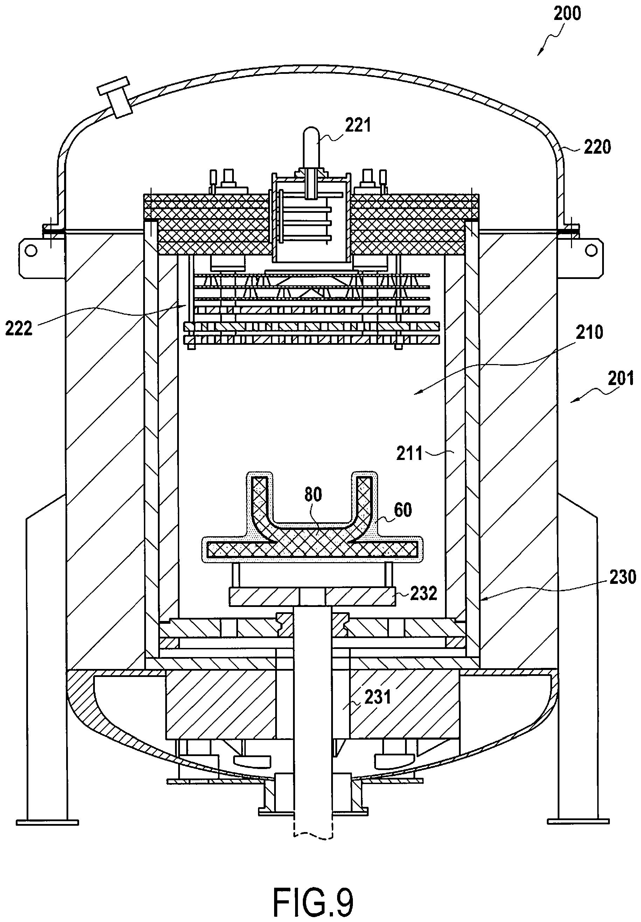

Une fois la carapace formée, avec ou sans perforations ou passages supplémentaires, on procède à la consolidation par infiltration chimique en phase gazeuse de la préforme fibreuse (étape S10). A cet effet, comme illustrée sur la figure 9, la préforme 80 maintenue à l'intérieur de la carapace 60 est placée dans une installation ou four d'infiltration chimique en phase gazeuse 200. De façon connue en soi, l'installation d'infiltration chimique en phase gazeuse 200 comprend une enceinte cylindrique 201 délimitant une chambre de réaction 210 fermée dans sa partie supérieure par un couvercle démontable 220 muni d'une conduite d'admission de gaz 221 qui débouche dans une zone de préchauffage 222 permettant de réchauffer le gaz avant sa diffusion dans la chambre de réaction 210 contenant la ou les préformes à densifier. Les gaz résiduels sont extraits au niveau du fond 230 de l'installation par une conduite d'évacuation 231 qui est reliée à des moyens d'aspiration (non représentés). Le fond 230 comporte un support 232 sur lequel la préforme 40 entourée de la carapace 60 est destinée à être déposée.

Le chauffage dans la zone préchauffage ainsi qu'à l'intérieur de la chambre de réaction 210 est produit par un suscepteur en graphite 211 formant un induit couplé électromagnétiquement avec un inducteur (non représenté).

La préforme 80 est consolidée par infiltration chimique en phase gazeuse. Afin d'assurer la consolidation de la préforme, un gaz réactif contenant au moins un ou plusieurs précurseurs du matériau d'une interphase de consolidation est introduit dans la chambre de réaction 210. L'interphase déposée dans la préforme peut être notamment en carbone pyrolytique ou PyC, ou en nitrure de bore (BN), en carbone dopé au bore ou BC (avec 5%at à 20%at de bore, le reste étant du carbone), ou en carbure de silicium. L'épaisseur de l'interphase déposée est de préférence comprise entre 100 nm et 1500 nm. L'épaisseur totale de l'interphase et la première phase de matrice est choisie suffisante pour consolider la préforme fibreuse, c'est-à-dire pour lier entre elles les fibres de la préforme de façon suffisante pour que la préforme puisse être manipulée en conservant sa forme sans assistance d'outillage de maintien. Cette épaisseur peut être au moins égale à 500 nm. Après consolidation, la préforme reste poreuse, la porosité initiale n'étant par exemple comblée que pour une partie minoritaire par l'interphase et la première phase de matrice.

La réalisation de dépôts de PyC, BC, B₄C, Si-B-C, Si₃N₄, BN et SiC par CVI est connue. On pourra notamment se référer aux documents US 5 246 736, US 5 738 951, US 5 965 266, US 6 068 930 et US 6 284 358.

Une fois la consolidation terminée, on procède au décochage de la carapace qui est détruite mécaniquement afin de libérer, comme illustrée sur la figure 10 une préforme 100 correspondant à la préforme 80 consolidée (étape S11). La préforme 100 est autoporteuse et ne nécessite aucun outillage de maintien en forme pour les opérations ultérieures. La préforme 100 peut notamment être soumise aux étapes ultérieures de fabrication d'une pièce en matériau CMC, à savoir :
- injection d'une barbotine dans la préforme fibreuse (« Slurry Cast » ou « Slurry Transfer Molding »),
- infiltration de la préforme avec une composition à base de silicium fondu de manière à former une matrice céramique, processus de densification connu sous la désignation processus MI ("Melt Infiltration"),
- usinages,
- formation d'un revêtement.

Dans une variante de mise en œuvre, la carapace peut être conservée lors des opérations d'injection d'une barbotine et d'infiltration avec une composition à base de silicium fondu.

Un exemple de réalisation d'une préforme fibreuse consolidée destinée à la fabrication d'une pièce en matériau composite CMC selon un procédé conforme à l'invention est donné ci-dessous :
- réalisation d'une texture fibreuse par tissage tridimensionnel de type interlock de fibres SiC,
- imprégnation de la texture fibreuse avec de l'alcool polyvinylique (PVA),
- mise en forme de la texture fibreuse dans un moule métallique chauffé,
- refroidissement du moule,
- démoulage de la préforme fibreuse figée,
- enrobage de la préforme fibreuse avec une barbotine contenant un mélange de particules colloïdales de SiC à 85% atomique et de SiO₂ à 15% atomique,
- Séchage de la préforme enrobée à 150°C pendant 2 heures,
- frittage des particules enrobant la préforme fibreuse à 1000°C pendant 1 heure,
- consolidation par infiltration chimique en phase gazeuse de la préforme fibreuse avec du nitrure de bore (BN) déposée dans celle-ci à une température comprise entre 700°C et 900°C.

## Revendications

1. Procédé de réalisation d'une préforme fibreuse consolidée (100) destinée à la fabrication d'une pièce en matériau composite, comprenant les étapes de :
- mise en forme d'une texture fibreuse (10) dans un moule métallique chauffé (20), la texture étant imprégnée préalablement d'un matériau fugace ou fugitif (30), ou mise en forme d'une texture fibreuse dans un moule métallique et injection d'un matériau fugace ou fugitif dans la texture fibreuse maintenue en forme dans le moule métallique,
- refroidissement du moule,
- démoulage de la préforme fibreuse figée (40),
- enrobage de la préforme fibreuse avec une barbotine (50) contenant une poudre de particules céramique ou carbone,
- traitement thermique de la préforme fibreuse (40) enrobée de manière à former une carapace poreuse (60) autour de la préforme fibreuse par consolidation de la barbotine et à éliminer le matériau fugace ou fugitif (30) présent dans la préforme fibreuse,
- consolidation par infiltration chimique en phase gazeuse de la préforme fibreuse.

2. Procédé selon la revendication 1, dans lequel, avant l'étape de consolidation par infiltration chimique en phase gazeuse de la préforme fibreuse, des perçages sont réalisés dans la carapace poreuse (60).

3. Procédé selon la revendication 1, dans lequel le moule (120) comporte une cavité de moulage (121) présentant une forme correspondant à la forme de la préforme fibreuse à réaliser et un ou plusieurs canaux (122) s'étendant à partir de la cavité de moulage, le ou les canaux étant remplis par le matériau fugace ou fugitif (130) lors de l'injection de la texture fibreuse (110) dans le moule, le matériau fugace ou fugitif formant des éléments en saillie (141) sur la surface de la préforme (140) après démoulage de ladite préforme, les éléments en saillie étant éliminés lors du traitement thermique de manière à former des ouvertures de passage dans la carapace.

4. Procédé selon la revendication 1, comprenant en outre, après l'étape de démoulage de la préforme (40) et avant l'étape d'enrobage de la préforme avec une barbotine (50), la formation d'éléments en saillie sur la surface de la préforme.

5. Procédé selon l'une quelconque des revendications 1 à 4, dans lequel le matériau fugace ou fugitif (30) correspond à une cire à injecter ou une résine fugitive.

6. Procédé selon l'une quelconque des revendications 1 à 5, **caractérisé en ce que** la préforme fibreuse (40) est formée par une texture fibreuse (10) réalisée en une seule pièce par tissage tridimensionnel ou multicouche ou à partir d'une pluralité de strates fibreuses bidimensionnelles.

7. Procédé selon l'une quelconque des revendications 1 à 6, **caractérisé en ce que** la texture fibreuse (10) est réalisée à partir de fibres de carbure de silicium (SiC), de nitrure de silicium (Si₃N₄) ou de carbone (C).

8. Procédé selon l'une quelconque des revendications 1 à 7, dans lequel l'étape de consolidation par infiltration chimique en phase gazeuse de la préforme fibreuse (80) comprend le dépôt d'une interphase dans la préforme, l'interphase étant constituée d'un des matériaux suivants : carbone pyrolytique (PyC), nitrure de bore (BN), carbone dopé au bore (BC) et carbure de silicium (SiC).

9. Procédé de fabrication d'une pièce en matériau composite comprenant la réalisation d'une préforme consolidée (100) selon l'une quelconque des revendications 1 à 8, le procédé de fabrication comprenant en outre, après l'étape de consolidation par infiltration chimique en phase gazeuse, une étape de décochage de la carapace, une étape d'injection d'une barbotine dans la préforme fibreuse et une étape d'infiltration de la préforme avec une composition à base de silicium fondu de manière à former une matrice céramique dans ladite préforme.

10. Procédé de fabrication d'une pièce en matériau composite comprenant la réalisation d'une préforme consolidée selon l'une quelconque des revendications 1 à 8, le procédé de fabrication comprenant en outre, après l'étape de consolidation par infiltration chimique en phase gazeuse, une étape d'injection d'une barbotine dans la préforme fibreuse et une étape d'infiltration de la préforme avec une composition à base de silicium fondu de manière à former une matrice céramique dans ladite préforme.

## Patentansprüche

1. Verfahren zur Herstellung einer konsolidierten Faservorform (100), die zur Fertigung eines Bauteils aus Verbundmaterial bestimmt ist, das die folgenden Schritte umfasst:
- Formgebung einer Fasertextur (10) in einer erhitzten metallischen Form (20), wobei die Textur im Voraus mit einem vergänglichen oder flüchtigen Material (30) imprägniert wird, oder Formgebung einer Fasertextur in einer metallischen Form und Einspritzen eines vergänglichen oder flüchtigen Materials in die in der metallischen Form in Form gehaltene Fasertextur,
- Abkühlung der Form;
- Entformen der erstarrten Faservorform (40),
- Umhüllung der Faservorform mit einem Schlicker (50), der ein Pulver aus Keramik- oder Kohlenstoffpartikeln enthält,
- Wärmebehandlung der umhüllten Faservorform (40), derart, dass durch Konsolidierung des Schlickers eine poröse Maske (60) um die Faservorform gebildet wird und das vergängliche oder flüchtige Material (30), das in der Faservorform vorhanden ist, beseitigt wird,
- Konsolidierung der Faservorform durch chemische Infiltration in der Gasphase.

2. Verfahren nach Anspruch 1, wobei vor dem Schritt der Konsolidierung der Faservorform durch chemische Infiltration in der Gasphase Bohrungen in der porösen Maske (60) hergestellt werden.

3. Verfahren nach Anspruch 1, wobei die Form (120) einen Formhohlraum (121), der eine Form aufweist, die der Form der herzustellenden Faservorform entspricht, und einen oder mehrere Kanäle (122) umfasst, die sich ausgehend von dem Formhohlraum erstrecken, wobei der oder die Kanäle mit dem vergänglichen oder flüchtigen Material (130) beim Einspritzen der Fasertextur (110) in die Form gefüllt werden, wobei das vergängliche oder flüchtige Material nach dem Entformen der Vorform hervorstehende Elemente (141) auf der Oberfläche der Vorform (140) bildet, wobei die hervorstehenden Elemente bei der Wärmebehandlung beseitigt werden, derart, das Durchgangsöffnungen in der Maske gebildet werden.

4. Verfahren nach Anspruch 1, das ferner nach dem Schritt des Entformens der Vorform (40) und vor dem Schritt der Umhüllung der Vorform mit einem Schlicker (50) die Bildung hervorstehender Elemente auf der Oberfläche der Vorform umfasst.

5. Verfahren nach einem der Ansprüche 1 bis 4, wobei das vergängliche oder flüchtige Material (30) einem einzuspritzenden Wachs oder einem flüchtigen Harz entspricht.

6. Verfahren nach einem der Ansprüche 1 bis 5, **dadurch gekennzeichnet, dass** die Faservorform (40) durch eine Fasertextur (10) gebildet wird, die einteilig durch dreidimensionales oder mehrschichtiges Flechten oder ausgehend von einer Vielzahl zweidimensionaler Faserlagen hergestellt wird.

7. Verfahren nach einem der Ansprüche 1 bis 6, **dadurch gekennzeichnet, dass** die Faserstruktur (10) ausgehend von Siliziumcarbid-(SiC), Siliziumnitrid- (Si₃N₄) oder Kohlenstofffasern (C) hergestellt wird.

8. Verfahren nach einem der Ansprüche 1 bis 7, wobei der Schritt der Konsolidierung der Faservorform (80) durch chemische Infiltration in der Gasphase das Abscheiden einer Zwischenphase umfasst, die aus einem der folgenden Materialien besteht: Pyrokohlenstoff (PyC), Bornitrid (BN), mit Bor dotierter Kohlenstoff (BC) und Siliziumcarbid (SiC).

9. Verfahren zur Fertigung eines Bauteils aus Verbundmaterial, das die Herstellung einer konsolidierten Vorform (100) nach einem der Ansprüche 1 bis 8 umfasst, wobei das Herstellungsverfahren ferner nach dem Schritt der Konsolidierung durch chemische Infiltration in der Gasphase einen Schritt der Ablösung der Maske, einen Schritt der Einspritzung eines Schlickers in die Faservorform und einen Schritt der Infiltration der Vorform mit einer Zusammensetzung auf Basis von geschmolzenem Silizium umfasst, derart, dass eine Keramikmatrix in der Vorform gebildet wird.

10. Verfahren zur Fertigung eines Teils aus Verbundmaterial, das die Fertigung einer konsolidierten Vorform nach einem der Ansprüche 1 bis 8 umfasst, wobei das Fertigungsverfahren ferner nach dem Schritt der Konsolidierung durch chemische Infiltration in der Gasphase einen Schritt der Einspritzung eines Schlickers in die Faservorform und einen Schritt der Infiltration der Vorform mit einer Zusammensetzung auf Basis von geschmolzenem Silizium umfasst, derart, dass eine Keramikmatrix in der Vorform gebildet wird.

## Claims

1. A method for producing a consolidated fiber preform (100) intended for the manufacture of a part made of composite material, comprising the steps of:
- shaping a fiber texture (10) in a heated metal mold (20), the texture being pre-impregnated with a transient or fugitive material (30), or shaping a fiber texture in a metal mold and injecting a transient or fugitive material into the fiber texture held in shape in the metal mold,
- cooling the mold,
- removing the set fiber preform (40) from the mold,
- coating the fiber preform with a slurry (50) containing a powder of ceramic or carbon particles,
- heat-treating the coated fiber preform (40) so as to form a porous shell (60) around the fiber preform by consolidation of the slurry and so as to remove the transient or fugitive material (30) present in the fiber preform,
- consolidating the fiber preform by gas-phase chemical infiltration.

2. The method according to claim 1, wherein, before the step for consolidating the fiber preform by gas-phase chemical infiltration, piercings are made in the shell (60).

3. The method according to claim 1, wherein the mold (120) includes a molding cavity (121) having a shape corresponding to the shape of the fiber preform to be produced and one or several channels (122) extending from the molding cavity, the channel(s) being filled with the transient or fugitive material (130) during the injection of the fiber texture (110) into the mold, the transient or fugitive material forming protruding elements (141) on the surface of the preform (140) after removal of said preform, the protruding elements being eliminated during the heat treatment so as to form passage openings in the shell.

4. The method according to claim 1, further comprising, after the step for removing the preform (40) from the mold and before the step for coating the preform with a slurry (50), the formation of protruding elements on the surface of the preform.

5. The method according to any one of claims 1 to 4, wherein the transient or fugitive material (30) corresponds to a wax to be injected or a fugitive resin.

6. The method according to any one of claims 1 to 5, **characterized in that** the fiber preform (40) is formed by a fiber texture (10) made in a single piece by three-dimensional or multilayer weaving or from a plurality of three-dimensional fiber layers.

7. The method according to any one of claims 1 to 6, **characterized in that** the fiber texture (10) is made from fibers of silicon carbide (SiC), silicon nitride (Si₃N₄) or carbon (C).

8. The method according to any one of claims 1 to 7, wherein the step for consolidation by chemical vapor infiltration of the fiber preform (80) comprises depositing an interphase in the preform, the interphase being made up of one of the following materials: pyrolytic carbon (PyC), boron nitride (BN), boron-doped carbon (BC) and silicon carbide (SiC).

9. A method for manufacturing a part made of composite material comprising producing a consolidated fiber preform (100) according to any one of claims 1 to 8, the manufacturing method further comprising, after the step for consolidation by vapor phase infiltration, a step for shaking out the shell, a step for injecting a slurry into the fiber preform and a step for infiltration of the preform with a molten silicon-based composition so as to form a ceramic matrix in said preform.

10. A method for manufacturing a part made of composite material comprising producing a consolidated preform according to any one of claims 1 to 8, the manufacturing method further comprising, after the step for consolidation by vapor phase infiltration, a step for injecting a slurry into the fiber preform and a step for infiltration of the preform with a molten silicon-based composition so as to form a ceramic matrix in said preform.
